# EUROPÄISCHE PATENTSCHRIFT

(11) **EP 1 047 806 B1**
(45) Veröffentlichungstag und Bekanntmachung des Hinweises auf die Patenterteilung: **16.04.2003**
(21) Anmeldenummer: 99901996.1
(22) Anmeldetag: 11.01.1999
(51) Int. Cl.: C23C 14/08, C23C 14/00

(54) **VERFAHREN ZUM BESCHICHTEN VON FOLIE AUS NICKEL ODER NICKELLEGIERUNG**
METHOD FOR COATING FOIL COMPRISED OF NICKEL OR NICKEL ALLOY
PROCEDE D'APPLICATION DE REVETEMENT SUR UN FILM DE NICKEL OU D'ALLIAGE DE NICKEL

(30) Priorität: 12.01.1998 DE 19800758
(43) Veröffentlichungstag der Anmeldung: 02.11.2000
(73) Patentinhaber: STORK VECO B.V., 6961 LB Eerbeek (NL); Koninklijke Philips Electronics N.V., 5621 BA Eindhoven (NL)
(72) Erfinder: GULIKERS, Josephus, Gertudis, Wilhelmus, Pierre, NL-7323 RM Apeldoorn (NL); GOEDICKE, Klaus, D-01307 Dresden (DE); LIEBIG, Jörn-Steffen, D-01474 Malschendorf (DE); MALOBABIC, Peter, A-9020 Klagenfurt (AT); HOCHREITER, Erwin, A-9020 Klagenfurt (AT)
(74) Vertreter: Volmer, Johannes Cornelis
(86) Internationale Anmeldenummer: NL9900013
(87) Internationale Veröffentlichungsnummer: WO99035300

(56) Entgegenhaltungen:
- DE-A- 4 433 863
- US-A- 5 543 183
- FAN J C C: "Selective-black absorbers using sputtered cermet films" INTERNATIONAL CONFERENCE ON METALLURGICAL COATINGS, SAN FRANCISCO, CA, USA, 3-7 APRIL 1978, Bd. 54, Nr. 2, Seiten 139-148, XP002099734 ISSN 0040-6090, Thin Solid Films, 16 Oct. 1978, Switzerland

## Beschreibung

Die Erfindung betrifft ein Verfahren zum Beschichten von Folie aus Nickel oder einer Nickellegierung und eine beschichtete Folie aus Nickel oder einer Nickellegierung. Solche beschichtete Folien sind vorzugsweise lateral strukturiert und finden insbesondere als Scherfolien für Elektro-Rasierapparate Verwendung.

Derartige Scherfolien und andere Produkte auf der Basis von Nickelfolien werden meist durch galvanisches Abscheiden hergestellt Durch verschiedene Verfahrensvarianten gelingt es dabei, sowohl eine laterale Strukturierung mit Durchbrüchen als auch überstehende Teile, die eine Scherkante bilden, zu erzeugen.

Es wird in letzter Zeit angestrebt, diese Folien, die auswechselbar sind, aus verschiedenen Gründen visuell erkennbar und verwechslungsfrei zu kennzeichnen, um sie irrtumsfrei unterscheiden zu können, da ihre Anwendungsgebiete unterschiedlich sind.

Es ist bekannt, auf einer Nickelfolie eine 2.5 bis 3 µm dicke Metallschicht aufzubringen. Anschließend wird diese Schicht anodisch oder in einem Plasma in ein Oxid oder Hydroxid überführt (JP 610 648 72-A). Es besteht der Nachteil, dass dieses Verfahren relativ kompliziert und die Haftfestigkeit der Schicht gering ist. Es lassen sich nur Schichten in wenigen Farben herstellen, und die Schneideigenschaften werden durch eine solche Schicht mit der angegebenen Dicke verschlechtert

Es ist weiterhin bekannt, auf Schneidwerkzeugen und Rasierklingen farbige Schichten durch Tauchen und galvanisches Behandeln von Stahlwerkstoffen in Chromsäure und Schwefelsäure zu erzeugen (GB 1 407 407; US 5.528.833; DE 21 26 129 Al; DE 22 30 157; AT 304 996). Nachteilig ist, dass bei der Abscheidung derartiger Schichten ferritische und austenitische Stähle und Behandlungstemperaturen von etwa 300 bis 700 °C erforderlich sind, so dass diese Verfahren auf dünne Nickelfolien nicht übertragbar sind.

Es ist weiterhin bekannt, auf Rasierklingen eine Unterschicht aus galvanisch aufgetragenem Kupfer und eine weitere metallische Schicht aufzubringen, um den Verschleiß und damit das Ende der Gebrauchsdauer von Rasierklingen optisch anzuzeigen (DE 35 33 238). Danach sind unterscheidbare Farben der Schicht jedoch nicht herstellbar, und alle anderen genannten Forderungen, außer der indikation des Verschleißes, werden von derartigen Schichten nicht erfüllt.

Weiterhin ist es bekannt, auf Rasierklingen sichtbare Marken oder organische Oxydationsindikatoren von veränderlicher Farbe aufzubringen, um den Verschleiß und damit das Ende der Gebrauchsdauer von Rasierklingen anzuzeigen (US 3.879.844; US 5.603.161). Es ist auf diese Weise jedoch nicht möglich, mehrere und trotz ihrer Farbvielfalt gut unterscheidbare Beschichtungen herzustellen und die genannten übrigen Forderungen, die an derartige Schichten gestellt werden, zu erfüllen.

Weiterhin ist es bekannt, verschiedene Beschichtungen auf Schneidwerkzeugen, insbesondere auf Rasierfolien oder Scherfolien aufzubringen, damit die Schneideigenschaften und die Gebrauchsdauer erhöht werden. Diese Schichten besitzen eine Dicke von 0,1 bis 1 µm, bestehen aus Nitriden oder Karbiden der Metalle Ti, W oder Cr und sind durch Sputter Ion Plating oder Ion Plating abgeschieden. Dazu wird eine DC-Glimmentladung bei 300 °C vorgesehen (GB 2 123 039 A). Diese Verbindungen können auch gefärbt sein, z.B. durch goldfarbenes Titannitrid. Für die Beschichtung galvanisch hergestellter Nickelfolien sind diese genannten Verfahren und Schichtmaterialien jedoch nicht anwendbar, denn bedingt durch den galvanischen Herstellungsprozess und einen geringen Gehalt an Zusatzmaterialien, z.B. Schwefel, dürfen die Nicketfolien beim Aufbringen der Beschichtung nur auf maximal 100 °C erwärmt werden. Andernfalls setzt eine Versprödung der Folien ein, die zur Unbrauchbarkeit führt Nachteilig ist weiterhin die geringe Zahl und die geringe Brillanz der herstellbaren Farbschichten.

Es ist weiterhin bekannt, Schichten durch physikalische Dampfabscheidung aus Nitriden oder Karbiden der 4. und 6. Nebengruppe des Periodischen Systems der Elemente aufzubringen, die zu harten und farbigen Überzügen führen und eine Dicke von 0,1 bis 1 µm aufweisen. Diese Schichten sind z.B. goldfarben und weisen die gleichen Mängel bei der Anwendung für das Beschichten von Nickel-Scherfolien auf (DE 34 31 330 A1).

Zur Vermeidung der Nachteile der bekannten Verfahren ist es bekannt, eine Hochfunktionsschicht hoher Härte und einstellbarer Farbe auf Schneidwerkzeugen, z.B.

Rasierapparaten aufzubringen, die durch reaktives Aufdampfen in einem Vakuum bei einem Druck von 10⁻⁵ bis 10⁻⁴ mbar hergestellt werden. Dabei werden Metall-Oxynitride, speziell der Metalle Titan oder Zirkonium, abgeschieden. Der Metalldampf wird in einem Hochvakuum-Verdampfer oder mittels lonenquellen erzeugt Als Schichtdicke wird 0,3 µm angegeben. Es handelt sich dabei um die Eigenfarbe der entstehenden Schichten, aber es wird auch auf die Möglichkeit der Erzeugung von interferenzfarben hingewiesen (US 5.458.928). Derartig aufgebrachte Schichten, insbesondere solche im Dickenbereich von 0,3 µm, verschlechtern jedoch die Schärfe der Schneidkanten. Ferner ist es sehr schwierig, mit den bekannten Verfahren eine vorgegebene Dicke und hohe Gleichmäßigkeit der Beschichtung zu erreichen. Damit wird ein hoher Anteil farblich abweichender Nickelfolien erzeugt, oder man muss sich auf die Verwendung der Körperfarbe dieser Schichten beschränken. Es zeigt sich weiterhin, dass der Wärmeeintrag beim Beschichten infolge der zu hohen Bildungsenthalpie der vorgeschlagenen Zirkon- und Titanverbindungen für die Beschichtung dünner Nickelfolien zu hoch ist. Folien mit einer Gesamtdicke von 40 bis 55 µm, wie sie häufig verwendet werden, lassen sich nach diesen Verfahren deshalb nicht ohne Versprödung beschichten.

Insgesamt ist festzustellen, dass die bekannten Verfahren zur Herstellung von Scherfolien keine optimale Lösung darstellen. Die wesentlichen Anforderungen an derartige Scherfolien, wie visuelle verwechslungsfreie Kennzeichnung, differenzierte Verwendung für verschiedene Hauttypen oder Körperpartien, dekorative und ästhetisch ansprechende Gestaltung, Verhinderung von Nickelallergie bei Hautkontakt sowie hohe Gebrauchsdauer, werden mit allen bekannten Verfahren nicht erfüllt.

Der Erfindung liegt die Aufgabe zugrunde, ein Verfahren zum Beschichten von Folie aus Nickel oder einer Nickellegierung und eine beschichtete Folie aus Nickel oder einer Nickellegierung, vorzugsweise eine Scherfolie für Elektro-Rasierapparate, zu schaffen, die eine in beliebiger Farbe herstellbare, fest haftende, verschleißarme Schicht mit einer sehr geringen Dicke besitzt Hierbei besteht die spezielle Forderung, dass die Farbtoleranzen sehr gering und die Farbgleichmäßigkeit sehr hoch sein sollen. Das Verfahren soll hochproduktiv und wirtschaftlich, d.h. automatisierbar sein. Eine wesentliche Teilaufgabe besteht darin, dass das Beschichten ohne thermische Überlastung der Folien erfolgt, auch wenn es sich um Folien mit einer Dicke von nur 40 µm oder weniger handelt Eine weitere Aufgabe der Erfindung ist es, Folien mit einem Indikator für die Gebrauchsdauer bei abrasiver Belastung insbesondere beim Einsatz für Elektro-Rasierapparate, zu schaffen, die sich durch eine Einstellbarkeit dieses Indikators auf einen vorgegebenen Wertebereich auszeichnen.

Erfindungsgemäß wird die Aufgabe nach dem Verfahren gemäß Anspruch 1 gelöst In den Ansprüchen 2 bis 7 sind zweckmäßige Ausgestaltungen des Verfahrens beschrieben. Eine erfindungsgemäß beschichtete Folie ist in Anspruch 8 beschrieben.

Es wurde gefunden, dass das erfindungsgemäße Verfahren infolge der physikalischchemischen Eigenschaften des Oxids von Chrom oder Chromlegierungen zu einer vergleichsweise äußerst geringen thermischen Belastung beim Beschichten der vorzugsweise galvanisch hergestellten Folien aus Nickel oder einer Nickellegierung führt (nachfolgend als Folien bezeichnet). Vergleiche mit Titanoxid zeigen zum Beispiel, dass die spezifische thermische Belastung einer derartigen Folie, bezogen auf eine gleiche Schichtdicke, um den Faktor 4 bis 6 höher ist und das bereits genannte Problem der Versprödung der Folie aus Nickel zeigt Dagegen kann eine nach dem erfindungsgemäßen Verfahren beschichtete Folie, ohne zu brechen, um 180° gebogen werden; sie bleibt hochduktil. Es wurde weiterhin erreicht, dass die optischen Kennwerte, insbesondere der Brechungsindex und der Absorptionskoeffizient, geeignet sind, um farbig wirkende Interferenzschichten mit hoher Brillanz auf Folien zu erzeugen. Der Farbort nach DIN 5033 Teil 3, Deutscher Normenausschuss, Ausg. Jan. 1980, und dessen Benennung im CIELAB-System kann nach bekannten Berechnungmethoden bestimmt werden (siehe hierzu z.B. G. Kienel, Vakuumbeschichtung, VDI-Verlag, Band 3, S. 120 ff. und Band 4, S. 97 ff.). Damit lässt sich mittels einer Normfarbtafel umgekehrt auch die entsprechend dem erfindungsgemäßen Verfahren notwendige Schichtdicke für die gewünschte Farbe vorgeben und durch bekannte Mittel der Vakuum-Beschichtungstechnik einstellen. Die praktisch notwendige Farbtoleranz korrespondiert mit der Forderung nach einer Toleranz der Schichtdicke von (± 1 bis ±5 %) je nach Einsatzfall, also mit Toleranzen, die in der Zerstäubungstechnik erreichbar sind. Wird z.B. eine Zerstäubungseinrichtung mit langgestreckten Magnetron-Zerstäubungsquellen und einer linearen Bewegung von Folien relativ zu diesen Magnetron-Zerstäubungsquellen für die Durchführung des Verfahrens verwendet, so lassen sich diese Toleranzen mit hoher Ausbeute auch auf großflächigen Folien erreichen und damit die Interferenzfarbe in engen Grenzen konstanthalten.

Wesentlich für das genaue Erreichen der geforderten Farbe ist weiterhin der konstante Arbeitspunkt beim Durchführen des erfindungsgemäßen Verfahrens. Das KonsLanthaiten des Arbeitspunktes ist als vorteilhafte Ausgestaltung des Verfahrens in den Ansprüchen 6 und 7 beschrieben. Danach wird eine hohe Konstanz des Arbeitspunktes erreicht Bei konstantem Arbeitspunkt lassen sich die Stöchiometrie der oxidischen Chromverbindung und damit die optischen Kenngrößen sehr genau reproduzierbar einstellen.

Ein weiteres Wirkprinzip, das überraschend gefunden wurde, ist der spezifische, streng korrelierte Zusammenhang zwischen der Behandlung einer zu beschichtenden galvanisch hergestellten Folie in einem Plasma und der Abrasionsbeständigkeit besagter farbiger Interferenzschichten aus Chromoxid oder Oxiden einer Chromverbindung. Es wurde festgestellt, dass bei dem erfindungsgemäß angewendeten Argondruck von 10⁻² bis 10⁻³ mbar in einem Bereich von Prozessparametern mit einer lonenenergie von 300 bis 800 eV und einer lonenrate, die einer lonenstromdichte von 1 bis 4 mA/cm² entspricht, die Abrasionsbeständigkeit der Farbschichten genau eingestellt werden kann. Mit zunehmender Behandlungsdauer im Plasma nimmt die Abrasionsbeständigkeit, von schlechten Werten beginnend, zunächst linear zu, durchläuft danach ein breites Optimum und verringert sich bei noch größerer Behandlungsdauer wieder. Der zuletzt genannte Effekt tritt offensichtlich durch diffusionsinduzierte Degradationserscheinungen infolge geringer Anteile von Schwefel, die sich unvermeidbar in galvanisch erzeugten Folien befinden, ein. Diese Erkenntnisse werden bei dem erfindungsgemäßen Verfahren genutzt, um die Abrasionsbeständigkeit besagter farbiger Schichten hinreichend groß einzustellen.

Es ist aber auch besonders vorteilhaft, die Abrasionsbeständigkeit so definiert einzustellen, dass die angestrebte Nutzungsdauer der Folie, z.B. im Einsatz als Scherfolie eines Elektro-Rasierapparates, mit dem Verschleißbeginn der Farbschicht übereinstimmt. Die damit verbundene Farbänderung bzw. Farbaufhellung signalisiert das Ende der Nutzungsdauer.

Zweckmäßigerweise wird die notwendige Eichmessung zum Ermitteln der Werte für die Behandlungsdauer bei vorgegebener lonenrate und lonenenergie experimentell durch eine Versuchsreihe vorgenommen. Als kalibrierbares Testverfahren für die Abrasionsbeständigkeit der Farbschichten eignet sich z.B. das Prüfgerät Taber Abraser 5130 mit Pico Glossmaster 500 der Fa. Erichsen". welches eine rollende und reibende Belastung der Schichten mit einem Reibkörper genormter Härte erzeugt und den Glanzverlust der Schicht ermittelt.

Die Folien können nach dem erfindungsgemäßen Verfahren auf einer Seite oder auf beiden Seiten beschichtet werden. Es ist auch möglich, mit bekannten Mitteln nur einen oder mehrere Bereiche der Folie zu beschichten.

Eine zweckmäßige Ausgestaltung des Verfahrens besteht auch darin, dass die Folien während ihrer Behandlung im Plasma und während ihres Beschichtens auf magnetischem Wege mit einem Wärmepuffer verbunden werden. Dadurch kann, trotz der geringen Wärmekapazität der dünnen Folie und einer nicht unterschreitbaren thermischen Belastung bei der Plasmabehandlung und dem Beschichten der Folie, gesichert werden, dass die Temperatur der Folie um nicht mehr als 10 bis 50 K je nach Farbe, also Dicke der Oxidschicht, ansteigt

Es wird mit dem erfindungsgemäßen Verfahren in jeder seiner Ausgestaltungen vermieden. dass eine Folie beim Beschichten versprödet. Ein weiterer Vorteil ist es, dass mit dem Verfahren extrem dünne oxidische Beschichtungen von vorzugsweise galvanisch hergestellten Folien, die eine einstellbare Verschleißfestigkeit und Interferenzfarbe besitzen, herstellbar sind, wobei gute Schneideigenschaften erreicht werden, dies im Gegensatz zu farbigen, nach bekannten Verfahren hergestellten Schichten, welche typischerweise höhere Schichtdicken aufweisen. Die Schichten weisen eine hohe Brillanz der Farben auf und rufen bei Hautkontakten keine Allergien hervor.

An einem Ausführungsbeispiel wird die Erfindung nachfolgend näher beschrieben.

In den zugehörigen Zeichnungen zeigen:

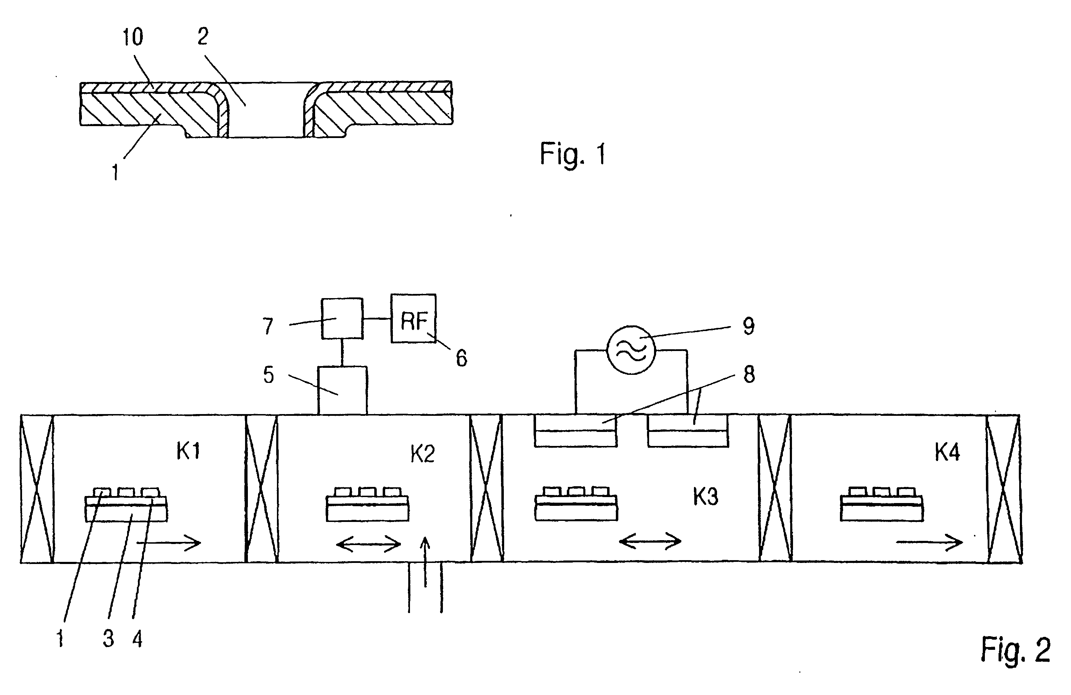

- Fig. 1:: einen Ausschnitt aus einer beschichteten Folie aus Nickel,
- Fig. 2:: ein Prinzip einer Einrichtung zum Durchführen des Beschichtungsverfahrens.

Nach der Erfindung werden Scherfolien für Elektro-Rasierapparate hergestellt.
Eine solche galvanisch hergestellte Folie 1 aus Nickel hat eine Dicke von 50 µm und besitzt ein Muster von Durchbrüchen 2 für die Barthaare. Die Folien 1 sollen typenabhängig markiert, ästhetisch-gestalterisch aufgewertet und in Bezug auf ihre mittlere Gebrauchsdauer markiert werden.
Das Verfahren wird in einer bekannten Mehrkammer-Zerstäubungsanlage mit linearem Durchlauf der zu beschichtenden Folien 1 ausgeführt. Die Folien 1 werden dazu auf Trägerplatten 3 aus 10 mm dicken Alu-Tafeln gelegt, die mit einer hartmagnetischen Polymerfolie 4 beklebt sind. Die Plasmabehandlung und das Beschichten erfolgt in Verbünden aus einzelnen Folien 1, die je eine Fläche von 80 cm x 50 cm bilden. Die magnetische Anziehungskraft der Polymerfolie 4 sichert einen definierten und intensiven Wärmekontakt zwischen den Folien 1 und den als Wärmepuffer wirkenden Trägerplatten 3. In der ersten Vakuumkammer K1 erfolgt das Einschleusen der Trägerplatten 3 mit den darauf haftenden Folien 1 in das Vakuum.
In der zweiten Vakuumkammer K2 wird mittels eines Gaseinlasses ein Argondruck von 3 10⁻³ mbar eingestellt Mittels einer lonenquelle S, die kapazitiv an eine radiofrequente Energiequelle 6 über ein Anpassnetzwerk 7 angekoppelt ist, wird ein homogener Strom von Ionen mit einer mittleren Stromdichte von 1 mA/cm² bei einer mittleren lonenenergie von 500 V erzeugt. Zur Plasmabehandlung wird die Trägerplatte 3 mit darauf haftenden Folien 1 pendelnd 10 mal mit einer Geschwindigkeit von 0,2 m/min durch den Strom von lonen bewegt, der durch die lonenquelle erzeugt wird.
In der dritten Kammer K3 erfolgt das Beschichten durch reaktives Magnetron-Zerstäuben zweier Chrom-Platten, die jeweils Target einer Magnetron-Zerstäubungsquelle 8 sind. Dazu wird mittels eines Gaseinlasssystems sowohl Argon als auch Sauerstoff eingelassen. Ein Sinusgenerator 9 speist eine Leistung von 10 kW in die gemeinsam arbeitenden Magnetron-Zerstäubungsquellen 8 derart ein, dass die Targets mit einer Frequenz von 50 kHz abwechselnd als Kathode und Anode einer Magnetron-Gasentladung geschaltet sind. Diese Art des als Dual-Magnetron-System bekannten Puls-Zerstäubens sichert einen langzeitstabilen Beschichtungsprozess in dem Argon Sauerstoff-Gemisch bei einem Druck von 2 - 10⁻³ mbar. Der Sauerstoffanteil wird dabei so geregelt, dass die Intensität einer charakteristischen Emissionslinie des Plasmas genau 10 % der Intensität beim Zerstäuben ohne Sauerstoff, d.h. im reinen Argon, beträgt.
Auch während des Beschichtens mit Chrom in der Kammer K3 wird die Trägerplatte 3 mit den Folien 1 periodisch mit einer festen Geschwindigkeit linear durch den Strom der kondensierenden Teilchen bewegt Bei einer Geschwindigkeit der Folie 1 von 0.12 m/min entsteht eine Schicht 10 mit einer Schichtdicke von 49 nm, bei einer Geschwindigkeit von 0.28 m/min eine Schicht 10 mit einer Schichtdicke von 21 nm.
Die gebildeten stöchiometrischen Chrom-Oxidschichten mit einer Schichtdicke in dem genannten Schichtdickenbereich auf den Folien 1 zeichnen sich durch hohe Abrasionsbeständigkeit und hohe Farbbrillanz aus. Die Interferenz der transparenten dünnen Schichten 10 auf Nickel erscheinen in brillantem Blau bzw. Gelb. Durch bekannte Maßnahmen der Gestaltung des Gaseiniasses und der Zerstäubungsquellen ist eine Homogenität der Schichtdicke und damit der Farbe gegeben, so dass alle Folien 1 des Verbundes gleiche Eigenschaften aufweisen.
in der Kammer K4 der Zerstäubungsanlage erfolgt das Ausschleusen der mit der Schicht 10 aus Chrom beschichteten Folien 1 aus dem Vakuum.
Die für die Vorbehandlung im Plasma eingestellten Parameter werden so gewählt, dass die durch die Schneideigenschaften der Scherfolie 1 gegebene mittlere Gebrauchsdauer etwa gleich lang ist wie der abrasiv an der farbigen Schicht 10 hervorgerufene Abnutzungsgrad, der einer sichtbaren Farbänderung entspricht.

## Patentansprüche

1. Verfahren zum Beschichten von Folie aus Nickel oder einer Nickellegierung, die vorzugsweise galvanisch hergestellt ist, durch Aufstäuben einer Schicht aus einer Metallverbindung in einem Vakuum auf die Folie im Bereich von mindestens einer Seite der Folie, **gekennzeichnet dadurch, dass**
- die Folie in einem Argonplasma bei einem Druck von 10⁻³ bis 10⁻² mbar eine einstellbare Zeit mit einer einstellbaren Rate und Energie der lonen des Plasmas behandelt wird,
- dass durch reaktives Magnetron-Zerstäuben mindestens eines Targets aus Chrom oder einer chromhaltigen Legierung mit mindestens einer Zerstäubungsquelle in einem Argon-Sauerstoff-Gemisch bei einem Druck von 10⁻³ bis 10⁻² mbar eine Chromoxidschicht aufgestäubt wird, wobei der Arbeitspunkt in vorgegebenen Grenzen konstant gehalten wird,
- dass die Folie während des Beschichtens in einem definierten Wärmekontakt mit einem Wärmepuffer verbunden wird,
- und dass die Folie bis zum Erreichen einer vorgegebenen Interferenzfarbe einer Interferenz erster oder zweiter Ordnung auf der Folie beschichtet wird.

2. Verfahren nach Anspruch 1, **dadurch gekennzeichnet, dass** zum reaktiven Magnetron-Zerstäuben in mindestens eine Zerstäubungsquelle mittelfrequenz gepulste Energie eingespeist wird.

3. Verfahren nach Anspruch 1 oder 2, **dadurch gekennzeichnet, dass** die Folie während des Beschichtens relativ zu der mindestens einen Zerstäubungsquelle bewegt wird und dass die Folie während des Beschichtens sich mindestens dreimal im Bereich der mit einer Zerstäubungsquelle zerstäubten Teilchen befindet.

4. Verfahren nach Anspruch 3, **dadurch gekennzeichnet, dass** die Folie relativ zu der mindestens einen Zerstäubungsquelle linear und periodisch bewegt wird.

5. Verfahren nach mindestens einem der Ansprüche 1 bis 4, **dadurch gekennzeichnet, dass** die Folie während der Durchführung des Verfahrens mit magnetischen Mitteln mit dem Wärmepuffer verbunden wird.

6. Verfahren nach mindestens einem der Ansprüche 1 bis 5. **dadurch gekennzeichnet, dass** der Arbeitspunkt eines mit einer Zerstäubungsquelle durchgeführten reaktiven Zerstäubungsprozesses durch Messen der optischen Emission des Plasmas in der Umgebung dieser Zerstäubungsquelle konstant gehalten wird.

7. Verfahren nach mindestens einem der Ansprüche 1 bis 5, **dadurch gekennzeichnet, dass** der Arbeitspunkt eines mit einer Zerstäubungsquelle durchgeführten reaktiven Zerstäubungsprozesses durch Messen einer elektrischen Kenngröße der Magnetron-Entladung dieser Zerstäubungsquelle konstant gehalten wird.

8. Beschichtete Folie aus Nickel oder einer Nickellegierung, die vorzugsweise nach einem galvanischen Verfahren hergestellt ist und auf die im Bereich von mindestens einer Seite eine in einem Vakuum aufgestäubte Schicht aus einer Metallverbindung aufgebracht ist, **dadurch gekennzeichnet, dass** die Schicht (10) aus einem Oxid des Chroms oder einer chromhaltigen Legierung besteht und dass die Dicke dieser Schicht (10) durch eine vorgegebene Interferenzfarbe einer interferenz erster oder zweiter Ordnung bestimmt ist und in einem Schichtdickenbereich zwischen 20 und 300 nm liegt.

## Claims

1. Process for coating foil comprised of nickel or a nickel alloy, which is preferably produced by electrodeposition, by sputtering a film of a metal compound onto the foil in vacuo in the area of at least one side of the foil, **characterized in that**
- the foil is treated in an argon plasma at a pressure of 10⁻³ to 10⁻² mbar, for an adjustable time and with an adjustable rate and energy of the ions of the plasma,
- a chromium oxide film is sputtered on by reactive magnetron sputtering of at least one target made from chromium or a chromium-containing alloy using at least one sputtering source in an argon-oxygen mixture at a pressure of 10⁻³ to 10⁻² mbar, the operating point being kept constant within defined limits,
- the foil is connected in defined thermal contact to a heat buffer during the coating,
- and the coating of the foil continues until a predetermined interference colour with an interference of the first or second order is reached.

2. Process according to claim 1, **characterized in that** medium-frequency-pulsed energy is fed to at least one sputtering source in order to effect the reactive magnetron sputtering.

3. Process according to claim 1 or 2, **characterized in that** the foil is moved relative to the at least one sputtering source during the coating, and **in that** on at least three occasions during the coating the foil is situated in the region of the particles which are sputtered using a sputtering source.

4. Process according to claim 3, **characterized in that** the foil is moved linearly and periodically relative to the at least one sputtering source.

5. Process according to any of claims 1-4, **characterized in that** the foil is connected to the heat buffer using magnetic means while the process is being carried out.

6. Process according to any of claims 1-5, **characterized in that** the operating point of a reactive sputtering process carried out using a sputtering source is kept constant by measuring the optical emission of the plasma in the vicinity of this sputtering source.

7. Process according to any of claims 1-5, **characterized in that** the operating point of a reactive sputtering process carried out using a sputtering source is kept constant by measuring an electrical characteristic of the magnetron discharge from this sputtering source.

8. Coated foil comprised of nickel or a nickel alloy which is preferably produced using an electrodeposition process and to which a film of a metal compound which is sputtered on in vacuo is applied in the area of at least one side, **characterized in that** the film (10) consists of an oxide of chromium or a chromium-containing alloy, and **in that** the thickness of this film (10) is determined by a specified interference colour with an interference of the first or second order and is in a film-thickness range of between 20 and 300 nm.

## Revendications

1. Procédé d'application d'un revêtement sur une feuille en nickel ou en un alliage de nickel, qui de préférence est fabriquée par voie électrolytique, par pulvérisation ou vaporisation sur la feuille, sous vide, d'une couche d'un composé de métal, sur une zone de la feuille correspondant à au moins une face de celle-ci,
**caractérisé**
- **en ce que** la feuille est traitée dans un plasma d'argon, à une pression de 10⁻³ à 10⁻² mbar, pendant un temps réglable, avec un taux et une énergie réglables des ions du plasma,
- **en ce que** par vaporisation réactive par magnétron d'au moins une cible en chrome ou alliage à teneur en chrome avec une source de vaporisation dans un mélange d'argon et d'oxygène, à une pression de 10⁻³ à 10⁻² mbar, on dépose par vaporisation une couche d'oxyde de chrome, le point de fonctionnement étant maintenu constant dans des limites prescrites,
- **en ce que** la feuille est reliée durant l'application du revêtement, par un contact calorifique défini, à un tampon calorifique,
- et **en ce que** l'application du revêtement sur la feuille se poursuit jusqu'à atteindre une teinte d'interférence prescrite d'une interférence de premier ou de second ordre.

2. Procédé selon la revendication 1, **caractérisé en ce que** pour la vaporisation réactive par magnétron, de l'énergie pulsée à moyenne fréquence est envoyée dans au moins une source de vaporisation.

3. Procédé selon la revendication 1 ou 2, **caractérisé en ce que** durant l'application du revêtement, la feuille est déplacée par rapport à ladite au moins une source de vaporisation, et **en ce que** la feuille, durant l'application du revêtement se trouve au moins trois fois dans la zone des particules vaporisées au moyen de la source de vaporisation.

4. Procédé selon la revendication 3, **caractérisé en ce que** la feuille est déplacée de manière linéaire et périodique par rapport à ladite au moins une source de vaporisation.

5. Procédé selon l'une au moins des revendications 1 à 4, **caractérisé en ce que** durant la mise en oeuvre du procédé, la feuille est reliée au tampon calorifique à l'aide de moyens magnétiques.

6. Procédé selon l'une au moins des revendications 1 à 5, **caractérisé en ce que** le point de fonctionnement d'un processus de vaporisation réactif effectué à l'aide d'une source de vaporisation, est maintenu constant par mesure de l'émission optique du plasma dans l'environnement de cette source de vaporisation.

7. Procédé selon l'une au moins des revendications 1 à 5, **caractérisé en ce que** le point de fonctionnement d'un processus de vaporisation réactif effectué à l'aide d'une source de vaporisation, est maintenu constant par mesure d'une grandeur électrique caractéristique de la décharge de magnétron de cette source de vaporisation.

8. Feuille de nickel ou d'alliage de nickel, revêtue, qui de préférence est fabriquée par voie électrolytique, et sur laquelle est appliquée, dans une zone correspondant à au moins une face, une couche d'un composé de métal déposée par vaporisation sous vide, **caractérisée en ce que** la couche (10) est formée par un oxyde de chrome ou d'un alliage à teneur en chrome, et **en ce que** l'épaisseur de cette couche (10) est déterminée par une teinte d'interférence prescrite d'une interférence de premier ou de second ordre et se situe dans une plage d'épaisseur de couche comprise entre 20 et 300nm.
